# EUROPEAN PATENT SPECIFICATION

(11) **EP 3 403 801 B1**
(45) Date of publication and mention of the grant of the patent: **02.03.2022**
(21) Application number: 17738572.1
(22) Date of filing: 13.01.2017
(51) Int. Cl.: B32B 5/26, B32B 5/28, B32B 15/14, B32B 15/20, C08J 5/24, H05K 1/03

(54) **FRP PRECURSOR, LAMINATED PLATE, METAL-CLAD LAMINATE, PRINTED CIRCUIT BOARD, SEMICONDUCTOR PACKAGE, AND METHOD FOR PRODUCING SAME**
FRP-VORLÄUFER, LAMINIERTE PLATTE, METALLKASCHIERTES LAMINAT, LEITERPLATTE, HALBLEITERGEHÄUSE UND VERFAHREN ZUR HERSTELLUNG DAVON
PRÉCURSEUR DE FRP, PLAQUE STRATIFIÉE, STRATIFIÉ À REVÊTEMENT MÉTALLIQUE, CARTE DE CIRCUIT IMPRIMÉ, BOÎTIER DE SEMI-CONDUCTEUR ET PROCÉDÉ DE PRODUCTION ASSOCIÉ

(30) Priority: 15.01.2016 JP 2016006476
(43) Date of publication of application: 21.11.2018
(73) Proprietor: Showa Denko Materials Co., Ltd., Tokyo 100-6606 (JP)
(72) Inventor: TOSAKA, Yuji, Tokyo 100-6606 (JP); SAITOH, Takeshi, Tokyo 100-6606 (JP); NAKAMURA, Yukio, Tokyo 100-6606 (JP); SASAKI, Ryohta, Tokyo 100-6606 (JP); SHIMIZU, Hiroshi, Tokyo 100-6606 (JP)
(74) Representative: Hoffmann Eitle
(86) International application number: PCT/JP2017/001134
(87) International publication number: WO 2017/122820

(56) References cited:
- WO-A1-2011/024870
- JP-A- H11 156 851
- JP-A- 2004 238 465
- JP-A- 2007 039 495
- JP-A- 2010 147 443
- JP-A- 2013 129 827
- DATABASE WPI Week 199934 Thomson Scientific, London, GB; AN 1999-399124 XP002792610, -& JP H11 156851 A (HITACHI CHEM CO LTD) 15 June 1999 (1999-06-15)
- DATABASE WPI Week 201338 Thomson Scientific, London, GB; AN 2013-J77104 XP002792611, -& JP 2013 129827 A (SUMITOMO BAKELITE CO LTD) 4 July 2013 (2013-07-04)
- DATABASE WPI Week 200726 Thomson Scientific, London, GB; AN 2007-262082 XP002792612, -& JP 2007 039495 A (SUMITOMO BAKELITE CO LTD) 15 February 2007 (2007-02-15)

## Description

### Technical Field

The present invention relates to a method for producing a metal-clad laminate.

### Background Art

FRP (Fiber-Reinforced Plastics) is a composite material using an aggregate having a high modulus such as fibers, wherein the aggregate is incorporated into a mother material (matrix) such as a plastic material thereby enhancing the strength thereof. Therefore, FRP is a composite material which is cheap, light, and excellent in the durability thereof because this utilizes its weatherability, lightness, and resistances to heat and chemicals. Because FRP can be molded and has high strength, it is used in a wide range of field such as a structural material in housing equipment, marine vessels, vehicles, air planes, etc., as well as electronic devices because of its electric insulating property. With regard to FRP used in the electronic devices, a prepreg may be exemplified, wherein especially the prepreg before being cured is occasionally called an FRP precursor.

Part of electronic parts of the electronic devices used in daily life is also produced using the FRP precursor. In view of the use convenience etc., the electronic parts are being required further reduction in the weight and size thereof. In the printed circuit board used in the electronic parts, too, the thickness and size thereof are being reduced, so that increase in fineness of a circuit pattern and reduction in thickness of an insulating layer are advancing; therefore, not only a glass cloth in the insulating layer but also a copper foil is being further thinned.

Meanwhile, nowadays, the printed circuit board is manufactured mainly by the method in which a prepreg, a copper foil, and, if necessary, an inner layer core substrate are stacked and then interposed between mirror plates, and they are hot pressed between hot plates to make a laminate thereby making it a copper-clad laminate having the copper foil in its outermost layer, which is followed by circuit processing and circuit connection by a subtractive process. Conventionally, without paying an attention to surface of the prepreg obtained from a thermosetting resin composition and a reinforcing substrate, the lamination thereof has been carried out under the state as they are. In spite of this, there have been no real problems because it has been made flat by pressing at the time of lamination. Therefore, such a process as to reduce a surface waviness of the prepreg, the process having been considered unnecessary, has not been carried out (see, for example, PTL 1). The reason for this is also because the copper foil has been sufficiently thick so that the mechanical strength thereof has been high.

### Citation List

### Patent Literature

PTL 1: Japanese Patent Laid-Open Publication No. 2004-342871

### Summary of Invention

### Technical Problems

However, with the requirement to reduce the copper foil's thickness, in recent years, the necessity is increasing to use the copper foil having the thickness of 40 µm or less. In this case, it was found by the study of inventors of the present invention that the conventional method for manufacturing the printed circuit board as mentioned before is prone to cause a light spot.

The investigation to clarify the reason for this revealed that because the prepreg is reinforced by a reinforcing substrate such as a glass cloth, irregularity derived from the reinforcing substrate gives a slight irregularity (surface waviness) to the prepreg's surface. It was presumed very likely that this irregularity (surface waviness) did not give any influence to the copper foil when the copper foil was sufficiently thick, but when the copper foil's thickness is 40 µm or less, the copper foil's mechanical strength is decreased so that the copper foil is influenced by this irregularity (surface waviness) thereby causing the light spot.

If the surface irregularity of the prepreg is too large, upon hot-pressing the copper foil with a conventional method, there is another problem that the irregular portion thereof contacts to a bonded surface of the copper foil thereby causing a press scratch on the copper foil surface or even possibly piercing the copper foil.

Meanwhile, there is a lamination method in which upon lamination the prepreg is heated without applying a pressure until the thermosetting resin therein reaches its softening temperature, and then the pressure is applied after the resin is softened, namely, the hot-press process is carried out by dividing it into two stages. However, in this two-stage process, because the process is held temporarily at the softening temperature, the time for lamination becomes so long that the productivity thereof decreases. In addition, because in this method, too, the softened thermosetting resin is influenced by the glass cloth, the irregularity of the prepreg's surface (surface waviness) remains, so that formation of the light spot cannot be sufficiently suppressed.

In view of the situation mentioned above, the present invention has an object to provide a method for producing a metal-clad laminate using an FRP precursor capable of providing a metal-clad laminate having small surface waviness and reduced number of the light spot, even if thickness of a metal foil is 40 µm or less.

Japanese Patent Laid-Open Publication No. H11-156851 provides a manufacturing method for a prepreg which has an excellent surface flatness by preventing an increase in resin solid content and an increase in viscosity of a resin varnish during coating work. In the method, a fiber base material is passed through a resin varnish tank filled with a resin varnish to impregnate the resin, then heated and dried in a drying furnace. The resin content is adjusted by a resin content adjusting bar which is in contact with the liquid surface of the resin varnish.

### Solution to Problems

Inventors of the present invention carried out an extensive investigation to solve the problems described above, and as a result, the present invention was completed.

The present invention relates to a method for producing a metal-clad laminate, wherein the method comprises:
(1) a process in which
   (i) a FRP precursor is interposed between releasing films and is then hot-pressed, or
   (ii) a FRP precursor is laminated on its both surfaces with thermosetting resin films to reduce a surface waviness on both surfaces of the FRP precursor to 12 µm or less;
(2) a process to laminate two or more of the FRP precursor obtained in the process (1); and
(3) a process to arrange a metal foil on the laminated plate obtained in the process (2),
wherein the thickness of the metal foil is 40 µm or less.

Further embodiments of the present invention are described in the appended claims.

### Advantageous Effects of Invention

According to the present invention, formation of the light spot in the metal foil of the metal-clad laminate can be suppressed although the thickness of the metal foil is 40 µm or less. Because of this, the risk of forming a press scratch on the metal foil's surface or piercing the metal foil can be decreased. In addition, the hot-press process at the time of producing the laminated plate does not need to be divided into two stages, so that the lamination condition is industrially advantageous.

### Brief Description of Drawings

[Fig. 1]
   (a) This is a schematic drawing illustrating the state just before lamination in the method for producing the metal-clad laminate of the present invention. (b) This is a schematic drawing illustrating the state after lamination in a method for producing the metal-clad laminate of the present invention.
[Fig. 2]
   (c) This is a schematic drawing illustrating the state just before lamination in the conventional method for producing the metal-clad laminate. (d) This is a schematic drawing illustrating the state after lamination in a conventional method for producing the metal-clad laminate.

### Description of Embodiments

### [FRP Precursor]

FRP (Fiber-Reinforced Plastics) is a composite material using an aggregate having a high modulus such as fibers, wherein the aggregate is incorporated into a mother material (matrix) such as a plastic material thereby enhancing the strength thereof. The FRP can be used in a wide range of field such as a structural material in housing equipment, marine vessels, vehicles, air planes, etc., as well as electronic devices. With regard to the FRP used in the electronic devices, a laminated plate which includes the prepreg for a printed circuit board may be cited, among others. Here, as the FRP precursor for the printed circuit board, the prepreg may be cited.

In the FRP precursor used in the present invention, the surface waviness is 12 µm or less on its both surfaces. The surface waviness is obtained from the waving curve in accordance with ISO 4287 (1997). More in detail, the surface waviness (sometimes called the waviness parameter) is measured with the surface roughness measurement instrument "Surf Test SV-3200" (manufactured by Mitutoyo Corp.). The surface waviness is the surface waviness on "both surfaces" of the FRP precursor unless otherwise noted. Therefore, for example, even if the surface waviness of one surface is 12 µm or less, if other surface thereof is more than 12 µm, the FRP precursor like this is not included in the present invention.

The surface waviness of the FRP precursor used in the present invention is preferably 10 µm or less, while more preferably 9 µm or less. There is no particular restriction in the lower limit value thereof, so that it may be 2 µm, or 4 µm, or 5 µm, or 6 µm.

When the surface waviness of the FRP precursor is 12 µm or less, even if thickness of the metal foil of the metal-clad laminate to be mentioned later is 40 µm or less, formation of the light spot in the metal foil of the metal-clad laminate can be suppressed. In addition, the risk that the press scratch is formed on the metal foil's surface or the metal foil is pierced can be reduced.

Further, it was found that in the case in which the metal foil of the metal-clad laminate is as thin as 40 µm or less, if the surface waviness is not within the afore-mentioned range, the metal foil warps thereby resulting in decrease in a tent property. The phenomenon like this does not appear if the metal foil is sufficiently thick, because the mechanical strength thereof is high in this case. It is presumed that when the surface waviness is made to 12 µm or less, a distance of the contact point thereof with that of the metal foil becomes shorter thereby enhancing the tent property of the metal foil, resulting in decrease in the surface waviness of the metal foil, thereby leading to the decrease in the number of the light spot. Meanwhile, the tent property of the metal foil means the property to keep the metal foil in a flat state when the metal foil is supported with a several fulcrums, and therefore a high tent property in the metal foil means that the property to keep the metal foil in a flat state without warping is high.

In addition, according to the FRP precursor used in the present invention, the hot-press process at the time of producing the laminated plate to be described later does not need to be divided into two stages, so that the lamination condition is industrially advantageous.

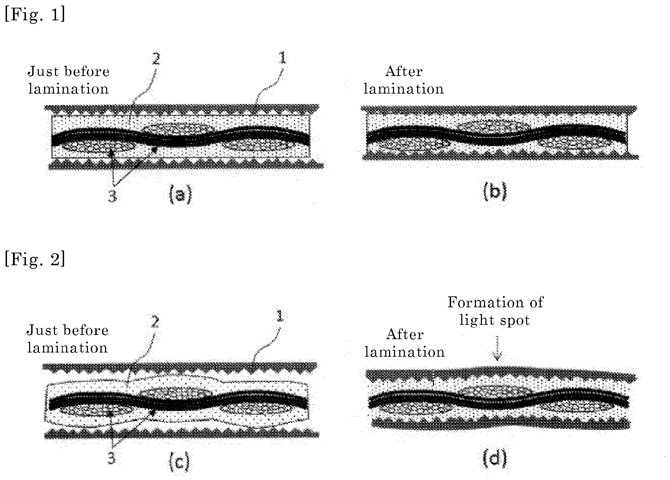

This phenomenon will be explained by using Fig. 1 and Fig. 2. Fig. 1(a) is a schematic drawing illustrating the state just before lamination in the method for producing the metal-clad laminate of the present invention. In Fig 1(a), the FRP precursor (prepreg) whose surface waviness is made to 12 µm or less is used, so that this belongs to the present invention. On the other hand, Fig. 2(c) is a schematic drawing illustrating the state just before lamination in a conventional method for producing the metal-clad laminate. In Fig. 2(c), the FRP precursor (prepreg) is used as it is when formed by a conventional method, so that there are some irregularities on surface of the FRP precursor (prepreg), so that this is the schematic drawing for comparison. Meanwhile, in both cases, the thin metal foil whose thickness is 12 µm is used.

Results of producing the respective metal-clad laminates by hot-press are illustrated in Fig. 1(b) and Fig. 2(d). In Fig. 1(b), the surface waviness of the metal foil is so small that the light spot is not formed. On the other hand, in Fig. 2(d), it is presumed that because the metal foil is influenced by the irregularity of the FRP precursor (prepreg), the light spot can be readily formed.

### [Method for Producing the FRP Precursor]

The FRP precursor (hereunder, the FRP precursor may be substituted with "prepreg") used in the present invention can be produced by the method for producing the FRP precursor wherein the method has (1) a process to reduce the surface waviness on both surfaces of the FRP precursor to 12 µm or less (hereunder, this process is called the process (1)).

The FRP precursor before its surface waviness is reduced to 12 µm or less, which is used in the process (1), can be produced with a conventional method. For example, in the case of prepreg, this corresponds to the one whose surface waviness is more than 12 µm, if it is produced by a conventional production method of the prepreg to be described later.

Next, the method to reduce the surface waviness to 12 µm is (i) the method in which the FRP precursor is hot-pressed with interposing it from above and below by a vacuum laminator or the like, or (ii) the method in which the FRP precursor is laminated on its both surfaces with thermosetting resin films.

In the method (i), the FRP precursor is interposed between releasing films, and then it is hot-pressed to reduce the surface waviness of the FRP precursor to 12 µm or less. Illustrative example of the releasing film includes: organic films such as polyethylene terephthalate (PET), biaxially drawn polypropylene (OPP), polyethylene, polyvinyl fluoride, and polyimide; metal films such as copper and aluminum, or alloy films of these metals; and these organic or metals films whose surface is treated with a release treatment by a releasing agent.

In the method (i), the hot-press condition is not particularly restricted, so that the condition within any range usually used by a person skilled in the art may be used. Specifically, the heating temperature is preferably in the range of 80 to 180°C, while more preferably in the range of 100 to 150°C. The pressure applied to the FRP precursor that is interposed between the releasing films is preferably in the range of 0.1 to 5 MPa, while more preferably in the range of 0.1 to 2 MPa. The heating time before pressing is preferably in the range of 5 to 60 seconds, while more preferably in the range of 5 to 40 seconds; and the heating time with pressing the FRP precursor is preferably in the range of 10 to 60 seconds, while more preferably in the range of 15 to 45 seconds.

Meanwhile, the method (i) is carried out preferably under vacuum. The evacuation degree is preferably -80 kPa (G) or less, while more preferably -90 kPa (G) or less.

In the method (ii), the thermosetting resin film is not particularly restricted, wherein the films formed by using the thermosetting resin compositions to be described later may be used. More specifically, the film formed by drying the thermosetting resin composition to be described later so as to remove an organic solvent and simultaneously carry out semi-curing thereof may be used.

Thickness of the thermosetting resin film (thickness of the thermosetting resin portion) is preferably in the range of 3 to 50 µm, more preferably in the range of 3 to 30 µm, still more preferably in the range of 3 to 15 µm, while especially preferably in the range of 3 to 10 µm.

Hereunder, the prepreg, which is one of the FRP precursors, will be specifically explained.

### [Prepreg]

The prepreg includes a reinforcing substrate and a thermoplastic resin composition therein. With regard to the reinforcing substrate of the prepreg, heretofore known materials used in various laminated plates for electric insulating materials may be used. Illustrative example of the material of the reinforcing substrate includes: natural fibers such as paper and cotton linter; inorganic fibers such as glass fibers and asbestos; organic fibers such as aramid, polyimides, polyvinyl alcohol, polyesters, tetrafluoroethylene, and acryls; and mixtures of them. Among them, in view of flame retardance, glass fibers are preferable. Illustrative example of the glass fiber substrate includes a woven fabric using E glass, C glass, D glass, S glass, or the like, or a woven glass fabric of short fibers bonded with an organic binder; and a mixed fabric of glass fibers and cellulose fibers. More preferable is the glass woven fabric using E glass.

These reinforcing substrates have the form of woven fabric, unwoven fabric, roving, chopped strand mat, surfacing mat, or the like. Meanwhile, the material and form thereof are chosen depending on the use or performance of the target shaped material, wherein they may be used singly or, if necessary, in a combination of two or more of the material and form thereof.

The prepreg can be produced, for example, in such a way that after the thermosetting resin composition is impregnated in or applied to the reinforcing substrate, it is semi-cured (converted to B-stage) by removal of an organic solvent, thermal curing, etc.. The heating temperature upon semi-curing thereof (conversion to B-stage) is equal to or higher than a boiling point of an organic solvent, because the organic solvent is simultaneously removed with curing. Therefore, the temperature is preferably in the range of 80 to 200°C, more preferably in the range of 140 to 180°C, because in this temperature range the organic solvent can be efficiently removed as well. Meanwhile, in the present invention, the prepreg obtained by semi-curing (conversion to B-stage) is regarded as an uncured prepreg, while the prepreg after being converted to the C-stage is regarded as the cured prepreg.

### (Thermosetting Resin Composition)

The thermosetting resin composition includes at least a thermosetting resin. Besides the thermosetting resin, the composition includes preferably at least any one selected from a curing agent, a curing facilitator, an inorganic filler, an organic filler, a coupling agent, a levelling agent, an anti-oxidant, a flame retardant, a flame retardant adjuvant, a thixotropic agent, a thickener, a flexible material, a surfactant, a photo-polymerization initiator, etc., if so desired.

Hereunder, each component included in the thermosetting resin composition will be explained in order.

### (Thermosetting Resin)

Illustrative example of the thermosetting resin includes epoxy resins, phenol resins, unsaturated imide resins, cyanate resins, isocyanate resins, benzoxazine resins, oxetane resins, amino resins, unsaturated polyester resins, allyl resins, dicyclopentadiene resins, silicone resins, triazine resins, and melamine resins. In addition, heretofore known thermosetting resins not particularly limited to the above-mentioned resins may be used. These may be used singly or concurrently as a mixture of two or more of them. Among them, epoxy resins are preferable in view of a molding property as well as an electric insulating property.

Illustrative example of the epoxy resin includes cresol novolak epoxy resins, phenol novolak epoxy resins, naphthol novolak epoxy resins, aralkyl novolak epoxy resins, biphenyl novolak epoxy resins, bisphenol A epoxy resins, bisphenol F epoxy resins, bisphenol S epoxy resins, bisphenol T epoxy resins, bisphenol Z epoxy resins, tetrabromobisphenol A epoxy resins, biphenyl epoxy resins, tetramethyl biphenyl epoxy resins, triphenyl epoxy resins, tetraphenyl epoxy resins, naphthol aralkyl epoxy resins, naphthalenediol aralkyl epoxy resins, naphthol aralkyl epoxy resins, fluorene epoxy resins, epoxy resins having a dicyclopentadiene skeleton, epoxy resins having a skeleton of an ethylenic unsaturated group, and alicyclic epoxy resins. These epoxy resins may be used singly, or in view of insulating reliability and heat resistance, concurrently as a mixture of two or more of them.

Illustrative example of the epoxy resin commercially available includes: as the cresol novolak epoxy resin, "EPICLON (registered trade mark) N-660" (manufactured by DIC Corp.); and as the bisphenol A epoxy resin, "EPICLON (registered trade mark) 840S" (manufactured by DIC Corp.) as well as "jER 828EL" and "YL 980" (both manufactured by Mitsubishi Chemical Corp.)

Meanwhile, the epoxy resin is not particularly restricted; however, in order to impart flexibility, what may also be used is the epoxy resin which has 2 or more epoxy groups in its molecular formula as well as in its main chain a structural unit derived from an alkylene glycol having 3 or more carbon atoms in its alkylene group. In order to further increase the flexibility, two or more of the structural unit derived from the alkylene glycol having 3 or more carbon atoms in its alkylene group may be continuously repeated.

With regard to the alkylene glycol having 3 or more carbon atoms in its alkylene group, an alkylene glycol having 4 or more carbon atoms in its alkylene group is preferable. The upper limit of the carbon atom in the alkylene group is not particularly limited, but it is preferably 15 or less, more preferably 10 or less, while still more preferably 8 or less.

In addition, in view of flame retardance, a halogenated epoxy resin may be used as the epoxy resin.

### (Curing Agent)

With regard to the curing agent, in the case where the thermosetting resin is the epoxy resin, illustrative example of the curing agent for the epoxy resin includes phenol type curing agents, cyanate ester type curing agents, acid anhydride type curing agents, amine type curing agents, and active ester group-containing compounds. Meanwhile, in the case where the thermosetting resin is other than the epoxy resin, curing agents heretofore known for the said thermosetting resin may be used. The curing agents may be used singly or concurrently as a mixture of two or more of them.

With regard to the phenol type curing agent, there is no particular restriction, wherein the preferable, illustrative example thereof includes cresol novolak type curing agents, biphenyl type curing agents, phenol novolak type curing agents, naphthylene ether type curing agents, and phenol type curing agents having a triazine skeleton.

Illustrative example of the phenol type curing agent commercially available includes: as the cresol novolak type curing agent, KA-1160, KA-1163, KA-1165, etc. (all manufactured by DIC Corp.); as the biphenyl type curing agent, MEH-7700, MEH-7810, MEH-7851, etc. (all manufactured by Meiwa Plastic Industries, Ltd.); as the phenol novolak type curing agent, Phenolite (registered trade mark) TD2090, etc. (manufactured by DIC Corp.); as the naphthylene ether type curing agent, EXB-6000 etc. (manufactured by DIC Corp.); and as the phenol type curing agent having a triazine skeleton, LA3018, LA7052, LA7054, LA1356, etc. (all manufactured by DIC Corp.).

With regard to the cyanate ester type curing agent, there is no particular restriction, wherein illustrative example thereof includes bisphenol A dicyanate, polyphenol cyanate (oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-diemethylphenyl)methane, 1,3-bis(4-cyanatephenyl-1-(methylethylidene))benzene, bis(4-cyanatephenyl) thioether, and bis(4-cyanatephenyl) ether.

With regard to the acid anhydride type curing agent, there is no particular restriction, wherein illustrative example thereof includes phthalic anhydride, tetrahydrophthalic anhydride, hexahydrophthalic anhydride, methyl tetrahydrophthalic anhydride, methyl hexahydrophthalic anhydride, methyl nadic anhydride, hydrogenated methyl nadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, and pyromellitic anhydride.

With regard to the amine type curing agent, there is no particular restriction, wherein illustrative example thereof includes aliphatic amines such as triethylene tetramine, tetraethylene pentamine, and diethylaminopropylamine; and aromatic amines such as m-phenylene diamine and 4,4'-diaminodiphenylmethane.

In addition, a urea resin, etc., may be used as the curing agent.

When the thermosetting resin composition includes the curing agent, the content thereof is preferably in the range of 20 to 150 parts by mass, more preferably in the range of 20 to 100 parts by mass, while still more preferably in the range of 40 to 100 parts by mass, relative to 100 parts by mass of the thermosetting resin.

Meanwhile, when the thermosetting resin composition includes the curing agent, the content thereof may also be expressed by the equivalent of the functional group thereof, while it is preferable to do so. Specifically, the curing agent is included therein preferably such that (mass of thermosetting resin/equivalent of functional group) is nearly equal to (mass of curing agent/equivalent of thermosetting resin-reactive functional group)×(constant C). The constant C is different depending on the functional group of the curing agent, wherein in the case where the functional group is a phenolic hydroxyl group, it is preferably in the range of 0.8 to 1.2; in the case of an amino group it is preferably in the range of 0.2 to 0.4; and in the case of an active ester group it is preferably in the range of 0.3 to 0.6.

In the case where the thermosetting resin is the epoxy resin, the foregoing equation is expressed such that (mass of epoxy resin/equivalent of epoxy group) is nearly equal to (mass of curing agent/equivalent of epoxy-reactive functional group) × (constant C).

### (Curing Facilitator)

With regard to the curing facilitator, curing facilitators generally used for curing of the thermosetting resin may be used. For example, in the case where the thermosetting resin is the epoxy resin, illustrative example of the curing facilitator includes: imidazole compounds and derivatives thereof; phosphorous compounds; tertiary amine compounds; and quaternary ammonium compounds. In view of facilitation of the curing reaction, the imidazole compounds and the derivatives thereof are preferable.

Specific example of the imidazole compound and the derivative thereof includes: imidazole compounds such as 2-methylimidazole, 2-ethylimidazole, 2-undecylimidazole, 2-heptadecylimidazole, 2-phenylimidazole, 1,2-dimethylimidazole, 2-ethyl-1-methylimidazole, 1,2-diethyl imidazole, 1-ethyl-2-methylimidazole, 2-ethyl-4-methylimidazole, 4-ethyl-2-methylimidazole, 1-isobutyl-2-methylimidazole, 2-phenyl-4-methylimidazole, 1-benzyl-2-phenylimidazole, 1-cyanoethyl-2-methylimidazole, 1-cyanoethyl-2-ethylimidazole, 1-cyanoethyl-2-phenylimidazole, 1-cyanoethyl-2-ethyl-4-methylimidazole, 2-phenyl-4,5-dihydroxymethylimidazole, 2-phenyl-4-methyl-5-hydroxymethylimidazole, 2,3-dihydro-1H-pyrro[1,2-a]benzimidazole, 2,4-diamino-6-[2'-methylimidazolyl-(1')]ethyl-s-triazine, 2,4-diamino-6-[2'-undecylimidazolyl-(1')]ethyl-s-triazine, and 2,4-diamino-6-[2'-ethyl-4'-methylimidazolyl-(1')]ethyl-s-triazine; salts of the above-mentioned imidazole compounds with trimellitic acid, such as 1-cyanoethyl-2-phenylimidazolium trimellitate; salts of the above-mentioned imidazole compounds with isocyanuric acid; and salts of the above-mentioned imidazole compounds with hydrobromic acid. These imidazole compounds may be used singly or concurrently as a mixture of two or more of them.

When the thermosetting resin composition includes the curing facilitator, the content thereof is preferably in the range of 0.1 to 20 parts by mass, more preferably in the range of 0.1 to 10 parts by mass, while still more preferably in the range of 0.5 to 6 parts by mass, relative to 100 parts by mass of the thermosetting resin.

### (Inorganic Filler)

By using an inorganic filler, the thermal expansion rate can be decreased, and the film strength can be enhanced.

Illustrative example of the inorganic filler includes silica, alumina, barium sulfate, talc, mica, kaolin, boehmite, beryllia, barium titanate, potassium titanate, strontium titanate, calcium titanate, aluminum carbonate, magnesium hydroxide, aluminum hydroxide, aluminum borate, aluminum silicate, calcium carbonate, calcium silicate, magnesium silicate, zinc borate, zinc stannate, aluminum oxide, zirconia, mullite, magnesia, zinc oxide, titanium oxide, silicon carbide, silicon nitride, boron nitride, clay such as calcined clay, glass short fibers, glass powders, and hollow glass beads, wherein at least any one selected from the group consisting of these inorganic fillers is preferably used. Illustrative, preferable example of the glass includes E glass, T glass, and D glass. Among them, in view of reducing the expansion rate, relative dielectric constant, and dielectric tangent, silica and alumina are preferable, while silica is more preferable.

With regard to the silica, precipitated silica with high water content that is produced with a wet method and dry silica hardly including bound water, etc., that is produced with a dry method may be cited. With regard to the dry silica, depending on difference in the production method thereof, crushed silica, fumed silica, and fused silica (fused spherical silica) may be cited.

The inorganic filler may be treated in the surface thereof with a surface modifying agent such as a silane coupling agent in order to enhance its moisture resistance; and also it may be treated with an agent to make it hydrophobic in order to enhance its dispersion property.

The inorganic filler can be selected arbitrarily in accordance with the purpose thereof. In view of easiness in forming a fine circuit, specific surface area of the inorganic filler is preferably 20 m²/g or more, more preferably in the range of 30 to 250 m²/g, while still more preferably in the range of 100 to 250 m²/g. The specific surface area of the inorganic filler can be obtained with a measurement method usually used by a person skilled in the art, for example, with a BET method. In the BET method, a molecule whose adsorption occupied area is known is adsorbed on the powder particle surface at the liquid nitrogen temperature so that the specific surface area of the sample is obtained from the amount thereof. The most frequently used method in the specific surface area analysis is the BET method using an inert gas such as nitrogen.

The inorganic filler includes an inorganic filler whose average primary particle's diameter is preferably 100 nm or less, whereas the average primary particle's diameter thereof is more preferably in the range of 1 to 80 nm, still more preferably in the range of 1 to 50 nm, further still more preferably in the range of 5 to 30 nm, while particularly preferably in the range of 10 to 30 nm. Meanwhile, "average primary particle's diameter" means the average particle's diameter of the single particle not aggregated, in other words it does not mean the average diameter of the aggregated particle, namely not the secondary particle's diameter. The average primary particle's diameter can be obtained by measurement with a laser diffraction particle size distribution analyzer. The average primary particle's diameter is the particle's diameter just at the volume of 50% in the cumulative frequency distribution curve of the particle's diameter in which total volume of the particle is taken as 100%.

Illustrative example of the inorganic filler commercially available, having the average primary particle's diameter of 100 nm or less, includes: AEROSIL 200 (specific surface area of 200±25 m²/g and average primary particle's diameter of about 15 to 16 nm (catalogue values)), AEROSIL R972 (specific surface area of 110±20 m²/g and average primary particle's diameter of about 16 nm (catalogue values)), and AEROSIL R202 (specific surface area of 100±20 m²/g and average primary particle's diameter of about 14 nm (catalogue values)), all of them (registered trade mark) are manufactured by Nippon Aerosil Co., Ltd.; PL-1 (specific surface area of 181 m²/g and average primary particle's diameter of 15 nm (catalogue values)) and PL-7 (specific surface area of 36 m²/g and average primary particle's diameter of 75 nm (catalogue values)), both (commercial names) are manufactured by Fuso Chemical Co., Ltd.; AL-A06 (commercial name; specific surface area; 55 m²/g (catalogue values), manufactured by CIK Nano Tek Corp.); and "SO-Cl" (commercial name, spherical silica, specific surface area of 17 m²/g (catalogue values), manufactured by Admatechs Co., Ltd.)

Together with the inorganic filler whose average particle's diameter of 100 nm or less, the inorganic filler may further include an inorganic filler whose average primary particle's diameter is in the range of 0.1 to 50 µm. The average primary particle's diameter of the said inorganic filler is more preferably in the range of 0.1 to 30 µm, still more preferably in the range of 0.5 to 15 µm, while particularly preferably in the range of 0.5 to 7 µm.

When the thermosetting resin composition includes the inorganic filler, the content thereof is preferably in the range of 0.1 to 65% by volume, though the content is different depending on the addition purpose. For the purposes of coloring and non-transmittance of a light, the amount of 0.1% or more by volume is prone to express sufficient effect. On the other hand, for the purpose to increase the volume, when the volume thereof is kept in the level of 65% or less by volume, not only the decrease in the adhesion strength is prone to be suppressed but also the decrease in workability is prone to be suppressed because the viscosity during the time of blending of the resin component is not too high. From the same view point, the content of the inorganic filler is more preferably in the range of 5 to 50% by volume, while still more preferably in the range of 10 to 40% by volume.

### (Coupling Agent)

The inorganic and organic fillers can increase in the dispersion property thereof, as well as in the adhesion property thereof with the reinforcing substrate and metal foil, when a coupling agent is included therein. The coupling agent may be used singly or concurrently as a mixture of two or more of it.

With regard to the coupling agent, a silane coupling agent is preferable. Illustrative example of the silane coupling agent includes aminosilane coupling agents [for example, 3-aminopropyl trimethoxy silane and N-(2-aminoethyl)-3-aminopropyl triethoxy silane], epoxy silane coupling agents [for example, 3-glycidoxypropyl trimethoxy silane and 2-(3,4-epoxycyclohexyl)ethyl trimethoxy silane], phenyl silane coupling agents, alkyl silane coupling agents, alkenyl silane coupling agents [for example, vinyl silane coupling agents such as vinyl trichlorosilane and vinyl triethoxy silane], alkynyl silane coupling agents, haloalkyl silane coupling agents, siloxane coupling agents, hydrosilane coupling agents, silazane coupling agents, alkoxy silane coupling agents, chlorosilane coupling agents, (meth)acryl silane coupling agents, aminosilane coupling agents, isocyanurate silane coupling agents, ureido silane coupling agents, mercapto silane coupling agents, sulfide silane coupling agents, and isocyanate silane coupling agents. Among them, epoxy silane coupling agents are preferable.

Besides, silane coupling agents whose silane moiety is substituted with titanate, so-called titanate coupling agents, may also be used.

When the thermosetting resin composition includes the coupling agent, the content thereof is preferably in the range of 0.1 to 20 parts by mass, more preferably in the range of 0.1 to 10 parts by mass, while still more preferably in the range of 0.5 to 6 parts by mass, relative to 100 parts by mass of the thermosetting resin.

### (Organic Solvent)

In order to improve workability, the resin composition may further include an organic solvent. In this specification, the resin composition including the organic solvent is sometimes called a resin varnish.

The organic solvent is not particularly restricted, wherein illustrative example thereof includes: alcoholic solvents such as methanol, ethanol, propanol, butanol, methyl cellosolve, butyl cellosolve, propylene glycol monomethyl ether, ethylene glycol monoethyl ether, dipropylene glycol monomethyl ether, ethylene glycol monoethyl ether, dipropylene glycol monomethyl ether, dipropylene glycol monoethyl ether, and tripropylene glycol monomethyl ether; ketonic solvents such as acetone, methyl ethyl ketone, methyl isobutyl ketone, butanone, cyclohexanone, and 4-methyl-2-pentanone; ester solvents such as ethyl acetate, butyl acetate, and propylene glycol monomethyl ether acetate; ether solvents such as tetrahydrofuran; aromatic solvents such as toluene, xylene, and mesitylene; nitrogen atom-containing solvents such as N,N-dimethylformamide, N,N-dimethylacetamide, and N-methyl pyrrolidone; and sulfur atom-containing solvents such as dimethyl sulfoxide. Among them, in view of solubility and appearance after coating, ketonic solvents are preferable, wherein cyclohexanone, methyl ethyl ketone, and methyl isobutyl ketone are more preferable, while cyclohexanone and methyl ethyl ketone are still more preferable.

These organic solvents may be used singly or concurrently as a mixture of two or more of them.

In view of coating easiness, use amount of the organic solvent is controlled, for example, such that content of non-volatile components in the resin composition is preferably in the range of 20 to 85 parts by mass, while more preferably in the range of 40 to 80% by mass.

On the other hand, if there is no problem in characteristics, a powder mixture in which the organic solvent is not used but the afore-mentioned components are mixed as powders may be used; or a change process to a water solution such as a suspension process may be used. Alternatively, at the temperature at which the thermosetting resin composition is not cured too much while undergoing liquefaction, the components may be directly mixed by stirring.

### (Preparation Method of Thermosetting Resin Composition)

There is no particular restriction in the preparation method of the thermosetting resin composition, so that heretofore known conventional methods may be used.

For example, after the thermosetting resin and, if necessary, other components are added into the organic solvent, they are mixed with stirring by using various mixing machines to prepare the composition as the resin varnish. Illustrative example of the type of the mixing machine includes an ultrasonic dispersion type, a high-pressure collision dispersion type, a high-speed rotation dispersion type, a bead mill type, a high-speed shearing dispersion type, and a planetary centrifugal dispersion type.

### [Laminated Plate and Metal-Clad Laminate]

By the method of the present invention, a laminated plate including the FRP precursor (prepreg) and eventually, a metal-clad laminate having a metal foil on the laminated plate are produced.

More specifically, the laminated plate is produced by lamination molding of the FRP precursors (prepregs) under the state that two or more, preferably 2 to 20, of them are stacked. A substrate that is processed with an inner layer circuit may be interposed between the FRP precursors (prepregs).

The metal-clad laminate is produced in such a way that after two or more, preferably 2 to 20, of the FRP precursors (prepregs) are stacked, the lamination molding is carried out under the configuration that a metal foil is arranged on one surface, or preferably on both surfaces, of the stack thus formed.

With regard to the lamination condition in the process (2), heretofore known conditions used in production of the laminated plate may be used. For example, by using a molding machine of a multi-stage press type, a multi-stage vacuum press type, a continuous molding type, an autoclave molding type, etc., the lamination may be carried out under the conditions with the temperature of 100 to 250°C, the pressure of 0.2 to 10 MPa, and the heating time of 0.1 to 5 hours.

In order to clearly express the effect of the present invention, thickness of the metal foil is 40 µm or less, preferably in the range of 1 to 40 µm, more preferably in the range of 5 to 40 µm, particularly preferably in the range of 5 to 35 µm, utmost preferably in the range of 5 to 25 µm, while further particularly preferably in the range of 5 to 17 µm.

In view of conductivity, metal of the metal foil is preferably copper, gold, silver, nickel. platinum, molybdenum, ruthenium, aluminum, tungsten, iron, titanium, chromium, as well as an alloy including at least one of the afore-mentioned metal elements. As the alloy, a copper alloy, an aluminum alloy, and an iron alloy are preferable. As the copper alloy, copper-nickel alloy may be cited. As the iron alloy, iron-nickel alloy (42 alloy) may be cited. Among them, as the metal, copper, nickel, and 42 alloy are more preferable, while copper is still more preferable in view of easy availability and cost thereof.

### [Printed Circuit Board]

By forming a circuit pattern on the laminated plate, the printed circuit board can be produced. The method for forming the circuit patterning is not particularly restricted, wherein illustrative example thereof includes heretofore known methods such as a subtractive process, a full additive process, a semi-additive process (SAP), and a modified semi-additive process (m-SAP).

### [Semiconductor Package]

The semiconductor package includes the printed circuit board; more specifically, it has a semiconductor mounted on the printed circuit board. The semiconductor package can be produced by mounting a semiconductor chip, a memory, or the like in the prescribed position on the printed circuit board.

### Examples

Next, the present invention will be explained in more detail by Examples described below; however, Examples described hereunder does not mean to restrict the present invention in any sense. Meanwhile, by using the prepreg or the copper-clad laminate prepared in each Example, the surface waviness and number of the light spot were measured by the following methods.

### (1. Surface Waviness)

By using the prepreg before lamination or the copper-clad laminate, prepared in each Example, the surface waviness obtained from the waving curve was measured in accordance with ISO 4287 (1997). More specifically, the surface waviness (waviness parameter) was measured by using the surface roughness measurement instrument "Surf Test SV-3200" (manufactured by Mitutoyo Corp.).

Meanwhile, the surface waviness was measured on both surfaces, and a larger value thereof was taken as the surface waviness.

### (2. Number of Light Spot)

By using the copper-clad laminate obtained from each Example, number of the light spot was measured in the area of 500 mm × 500 mm. The measurement was carried out under the condition in accordance with "IPC-TM-650 No.2.1.8 (finishing property)".

With reduced number of the light spot, the appearance thereof is better. In addition, because the light spot is formed by an unnatural force to the copper foil, with reduced number of the light spot the possibility that the copper foil is cracked in this position is less; therefore it is preferable.

### [Preparation Example 1]

### Preparation of Thermosetting Resin Composition (Thermosetting Resin Varnish 1)

Into a mixture of 100 parts by mass of "EPICLON (registered trade mark) N-660" (cresol novolak epoxy resin, manufactured by DIC Corp.), 10 parts by mass of "EPICLON 840S" (bisphenol A epoxy resin, manufactured by DIC Corp.), and 60 parts by mass of Phenolite (registered trade mark) TD2090" (phenol novolak resin, manufactured by DIC Corp.) were added 30 parts by mass of cyclohexanone and 120 parts by mass of methyl ethyl ketone; and then, they were stirred to thoroughly dissolve them. Into this was added 120 parts by mass of "CL-303" (aluminum hydroxide, manufactured by Sumitomo Chemical Co., Ltd.), 35 parts by mass of "FB-3SDC" (silica, manufactured by Denka Co., Ltd.), 3 parts by mass of "AEROSIL 200" (nanosilica, manufactured by Nippon Aerosil Co., Ltd.), 2 parts by mass of "A-187" (coupling agent, manufactured by Momentive Performance Materials, Inc.), and 2 parts by mass of "IBMI-12" (1-isobutyl-2-methyl imidazole (curing facilitator), manufactured by Mitsubishi Chemical Corp.). The resulting mixture was dissolved and dispersed by stirring to obtain the thermosetting resin varnish 1 with the nonvolatile component of 70% by mass (content of silica and nanosilica: 9% by volume, content of aluminum hydroxide: 25% by volume).

### [Example 1]

### Production of Prepreg and Copper-Clad Laminate (Production of Prepreg)

The thermosetting resin varnish 1 obtained in Preparation Example 1 was applied to the glass cloth (weight: 48 g/m², IPC #1080, substrate width: 530 mm, manufactured by Nitto Boseki Co., Ltd.) such that content of the resin component therein would become 62% by mass after being dried. Next, in order to remove the organic solvents and simultaneously carrying out semi-curing the thermosetting resin varnish 1, it was heated at 160°C with a hot air dryer to obtain the Prepreg a.

The Prepreg a was interposed from above and below between releasing aluminum foils "Sepanium 202BC" (manufactured by Toyo Aluminium K.K.), and then this was allowed to stand for 20 seconds at 120°C under vacuum using the vacuum laminator "MVLP 500" (manufactured by Meiki Co., Ltd.); and then, it was kept at the same temperature for 30 seconds with applying a pressure from one surface thereof (applied pressure: 0.5 MPa) to reduce the surface waviness to obtain the Prepreg A. The surface waviness of the Prepreg A was measured with the method described before. The result thereof is shown in Table 1.

### (Production of Copper-Clad Laminate)

Next, four sheets of the Prepreg A thus obtained were stacked, and then the stack was interposed between two copper foils "GTS-12" (thickness of 12 µm, manufactured by Furukawa Electric Co., Ltd.); then the copper-clad laminate was obtained under the lamination condition 1 or 2 described below. In accordance with the afore-mentioned methods, the surface waviness and number of the light spot of the copper-clad laminate thus obtained were measured. These results are summarized in Table 1.

### (Lamination Condition 1)

Temperature was raised from 25°C to 185°C with the temperature raising rate of 3°C/minute; and after the temperature was kept at 185°C for 90 minutes, it was cooled for 30 minutes (total 173 minutes).

Pressure to the product (pressure applied to four Prepregs A interposed between the copper foils): 4 MPa (from start of the temperature raise till termination of cooling).

### (Lamination Condition 2)

Temperature was raised from 25°C to 130°C with the temperature raising rate of 3°C/minute; and after the temperature was kept at 130°C for 15 minutes, it was raised to 185°C with the temperature raising rate of 3°C/minute; and after the temperature was kept at 185°C for 90 minutes, it was cooled for 30 minutes (total 188 minutes).

Pressure to the product (pressure applied to four Prepregs A interposed between the copper foils): 0.5 MPa (from start of the temperature raise till termination of keeping the temperature at 130°C), then 4MPa (till termination of cooling).

### [Example 2]

The copper-clad laminate was produced with the same procedure as Example 1 except that the copper foil "GTS-35MP" (thickness of 35 µm, manufactured by Furukawa Electric Co., Ltd.) was used in place of "GTS-12" (thickness of 12 µm, manufactured by Furukawa Electric Co., Ltd.). In accordance with the afore-mentioned methods, the surface waviness and number of the light spot of the copper-clad laminate thus obtained were measured. These results are summarized in Table 1.

### [Comparative Example 1]

The copper-clad laminate was produced with the same procedure as Example 1 except that the Prepreg a was used in place of the Prepreg A upon producing the copper-clad laminate; and the surface waviness and number of the light spot of the copper-clad laminate thus obtained were measured. These results are summarized in Table 1.

### [Comparative Example 2]

The copper-clad laminate was produced with the same procedure as Comparative Example 1 except that the copper foil "GTS-35MP" (thickness of 35 µm, manufactured by Furukawa Electric Co., Ltd.) was used in place of "GTS-12" (thickness of 12 µm, manufactured by Furukawa Electric Co., Ltd.). In accordance with the afore-mentioned methods, the surface waviness and number of the light spot of the copper-clad laminate thus obtained were measured. These results are summarized in Table 1.

### [Example 3]

The thermosetting resin varnish 1 obtained in Preparation Example 1 was applied onto the PET film "G-2" (width: 580 mm, manufactured by Teijin DuPont Films Japan Ltd.). At this time, the application amount was controlled such that the width became 525 mm with the thickness of 5 µm after being dried. After the application, it was dried to remove the organic solvents and simultaneously carry out semi-curing the thermosetting resin varnish 1 to obtain the thermosetting resin film A'.

The Prepreg a obtained in Example 1 was laminated on its both surfaces with the thermosetting resin film A'. Press rolling condition to obtain the laminate was made under a normal pressure with a roll temperature of 110°C, with a linear pressure of 0.25 MPa, and with the moving rate of 2.0 m/minute.

Then, it was cooled and rolled up by a cold roll to obtain the Prepreg B. In accordance with the afore-mentioned method, the surface waviness of the Prepreg B was measured. The result thereof is shown in Table 1.

Next, the copper-clad laminate was produced with the same procedure as Example 1 except that the Prepreg B was used in place of the Prepreg A. In accordance with the afore-mentioned methods, the surface waviness and number of the light spot of the copper-clad laminate thus obtained were measured. These results are summarized in Table 1.

### [Example 4]

The copper-clad laminate was produced with the same procedure as Example 3 except that the copper foil "GTS-35MP" (thickness of 35 µm, manufactured by Furukawa Electric Co., Ltd.) was used in place of "GTS-12" (thickness of 12 µm, manufactured by Furukawa Electric Co., Ltd.). In accordance with the afore-mentioned methods, the surface waviness and number of the light spot of the copper-clad laminate thus obtained were measured. These results are summarized in Table 1.

**[Table 1]**

| | | | Example | | | | Comparative Example | |
|---|---|---|---|---|---|---|---|---|
| | | | 1 | 2 | 3 | 4 | 1 | 2 |
| Measurement results | Surface waviness of Prepreg a | µm | 16.4 | 16.4 | 16.4 | 16.4 | 16.4 | 16.4 |
| | Surface waviness of Prepreg A or B | µm | 8.3 | 8.3 | 8.2 | 8.2 | | |
| | Used prepreg | | A | A | B | B | a | a |
| | Number of light spot (lamination condition 1) | | 5 | 5 | 2 | 0 | 23 | 11 |
| | Number of light spot (lamination condition 2) | | 1 | 0 | 0 | 0 | 3 | 1 |
| | Surface waviness of copper-clad laminate (lamination condition 1) | µm | 2.1 | 1.9 | 1.6 | 1.6 | 5.8 | 2.6 |
| | Surface waviness of copper-clad laminate (lamination condition 2) | µm | 1.8 | 1.6 | 1.1 | 1.2 | 3.4 | 1.9 |

From Table 1, it can be seen that in Examples 1 to 4, when the surface waviness of the prepreg was made to 12 µm or less, the surface waviness of the copper-clad could be reduced, and number of the light spots of the copper-clad laminate could be decreased. Therefore, it can be said that not only the risk that the press scratch is formed on the copper foil's surface or the copper foil is pierced can be reduced, but also the tent property of the copper foil is enhanced. Consequently, according to the present invention, even if the hot-press process at the time of producing the laminated plate is not divided into two stages, which is the process of mentioned-above, not only the surface waviness can be reduced but also number of the light spots can be decreased, so that this is industrially very advantageous.

On the other hand, in Comparative Examples 1 and 2, the light spot in the copper-clad laminate was many, and the surface waviness of the copper-clad laminate was large.

### Industrial Applicability

In the metal-clad laminate formed by using the production method of the present invention, although the thickness of the metal foil is 40 µm or less, not only the light spot is decreased but also the surface waviness is small, so that this is useful as the printed circuit board for electronic devices.

### Reference Signs List

- 1.: Metal foil
- 2.: Thermosetting resin composition
- 3.: Reinforcing substrate

## Claims

1. A method for producing a metal-clad laminate, wherein the method comprises:
(1) a process in which
(i) a FRP precursor is interposed between releasing films and is then hot-pressed, or
(ii) a FRP precursor is laminated on its both surfaces with thermosetting resin films to reduce a surface waviness on both surfaces of the FRP precursor to 12 µm or less, the surface waviness being measured in accordance with ISO 4287 (1997) as further illustrated in the description;
(2) a process to laminate two or more of the FRP precursor obtained in the process (1); and
(3) a process to arrange a metal foil on the laminated plate obtained in the process (2),
wherein the thickness of the metal foil is 40 µm or less.

2. The method for producing the metal-clad laminate according to claim 1, wherein the metal foil is a copper foil.

3. The method for producing a metal-clad laminate according to claim 1 or 2, wherein the FRP precursor comprises a reinforcing substrate and a thermosetting resin composition, the thermosetting resin composition comprising a thermosetting resin and at least one selected from the group consisting of a curing agent, a curing facilitator, an inorganic filler, an organic filler, a coupling agent, a levelling agent, an anti-oxidant, a flame retardant, a flame retardant adjuvant, a thixotropic agent, a thickener, a flexible material, a surfactant and a photo-polymerization initiator.

4. The method for producing a metal-clad laminate according to claim 3, wherein the thermosetting resin composition comprises an inorganic filler in an amount of 0.1 to 65 % by volume.

## Patentansprüche

1. Verfahren zur Herstellung eines metallkaschierten Laminats, wobei das Verfahren umfasst:
(1) ein Verfahren, in dem
(i) ein FRP-Vorläufer zwischen Trennfolien eingefügt wird und dann heißgepresst wird oder
(ii) ein FRP-Vorläufer auf seinen beiden Oberflächen mit wärmehärtenden Harzfolien laminiert wird,
um eine Oberflächenwelligkeit auf beiden Oberflächen des FRP-Vorläufers auf 12 µm oder weniger zu reduzieren, wobei die Oberflächenwelligkeit gemäß ISO 4287 (1997) gemessen wird, wie in der Beschreibung weiter erläutert wird;
(2) ein Verfahren zum Laminieren von zwei oder mehr des in Verfahren (1) erhaltenen FRP-Vorläufers und
(3) ein Verfahren zum Anordnen einer Metallfolie auf der im Verfahren (2) erhaltenen laminierten Platte,
wobei die Dicke der Metallfolie 40 µm oder weniger beträgt.

2. Verfahren zur Herstellung des metallkaschierten Laminats gemäß Anspruch 1, wobei die Folie eine Kupferfolie ist.

3. Verfahren zur Herstellung eines metallkaschierten Laminats gemäß Anspruch 1 oder 2, wobei der FRP-Vorläufer ein Verstärkungssubstrat und eine wärmehärtende Harzzusammensetzung umfasst, wobei die wärmhärtende Harzzusammensetzung ein wärmehärtendes Harz und mindestens eines, ausgewählt aus der Gruppe, bestehend aus einem Härtungsmittel, einem Härtungsvermittler, einem anorganischen Füllstoff, einem organischen Füllstoff, einem Haftvermittler, einem Egalisiermittel, einem Antioxidans, einem Flammschutzmittel, einem Flammschutzhilfsmittel, einem Thixotropiermittel, einem Verdickungsmittel, einem flexiblen Material, einem Tensid und einem Fotopolymerisationsinitiator, umfasst.

4. Verfahren zur Herstellung eines metallkaschierten Laminats gemäß Anspruch 3, wobei die wärmehärtende Harzzusammensetzung einen anorganischen Füllstoff in einer Menge von 0,1 bis 65 Volumen-% umfasst.

## Revendications

1. Procédé de production d'un stratifié revêtu de métal, dans lequel le procédé comprend :
(1) un processus dans lequel
(i) un précurseur FRP est interposé entre des films décollables, puis est pressé à chaud, ou
(ii) un précurseur FRP est stratifié, sur ses deux surfaces, avec des films de résine thermodurcissable
pour réduire une ondulation de surface sur les deux surfaces du précurseur FRP à 12 µm ou moins, l'ondulation de surface étant mesurée selon ISO 4287 (1997) comme cela est en outre illustré dans la description ;
(2) un processus pour stratifier deux précurseurs FRP ou plus obtenus dans le processus (1) ; et
(3) un processus pour agencer une feuille de métal sur la plaque stratifiée obtenue dans le processus (2),
dans lequel l'épaisseur de la feuille de métal est 40 µm ou moins.

2. Procédé de production du stratifié revêtu de métal selon la revendication 1, dans lequel la feuille de métal est une feuille de cuivre.

3. Procédé de production d'un stratifié revêtu de métal selon la revendication 1 ou 2, dans lequel le précurseur FRP comprend un substrat de renforcement et une composition de résine thermodurcissable, la composition de résine thermodurcissable comprenant une résine thermodurcissable et au moins l'un sélectionné dans le groupe consistant en un agent durcissant, un facilitateur de durcissement, une charge inorganique, une charge organique, un promoteur d'adhérence, un agent d'unisson, un antioxydant, un ignifugeant, un adjuvant ignifugeant, un agent thixotropique, un épaississant, un matériau souple, un tensioactif et un initiateur de photopolymérisation.

4. Procédé de production d'un stratifié revêtu de métal selon la revendication 3, dans lequel la composition de résine thermodurcissable comprend une charge inorganique dans une quantité de 0,1 à 65 % en volume.
